# EUROPÄISCHE PATENTSCHRIFT

(11) **EP 2 355 132 B1**
(45) Veröffentlichungstag und Bekanntmachung des Hinweises auf die Patenterteilung: **21.05.2014**
(21) Anmeldenummer: 10152682.0
(22) Anmeldetag: 04.02.2010
(51) Int. Cl.: H01L 21/67, H01L 21/677, F16K 1/20, F16K 51/02, E05F 15/04

(54) **Klappen-Transferventil mit schwenkbarem Ventilverschlussbalken**
Flap transfer valve with pivoting valve closure boards
Soupape de transfert à clapets dotée de barres de fermeture de soupape pivotantes

(43) Veröffentlichungstag der Anmeldung: 10.08.2011
(73) Patentinhaber: VAT Holding AG, 9469 Haag (CH)
(72) Erfinder: Geiser, Friedrich, A-6714, Nüziders (AT)
(74) Vertreter: Harmann, Bernd-Günther

(56) Entgegenhaltungen:
- EP-A2- 0 496 604
- DE-C- 802 855
- US-A- 3 084 904
- US-A- 4 785 962
- US-A- 5 205 532
- US-A- 5 275 303
- US-A1- 2005 274 923

## Beschreibung

Die Erfindung betrifft ein Klappen-Transferventil für den Transfer von Halbleiterelementen oder Substraten in eine gasdicht isolierbare Halbleiter- oder Substratbearbeitungs-Prozesskammer nach dem Oberbegriff des Anspruchs 1.

Ein derartiges Klappen-Transferventil ist aus der EP 0 554 522 bekannt.

Insbesondere im Bereich der IC- und Halbleiterfertigung, die in einer geschützten Atmosphäre möglichst ohne das Vorhandensein verunreinigender Partikel stattfinden muss, kommen diverse Vakuumventile zum Einsatz. Beispielsweise durchlaufen in einer Fertigungsanlage für Halbleiter-Wafer oder Flüssigkristall-Substrate die hochsensiblen Halbleiter-oder Flüssigkristall-Elemente sequentiell mehrere Prozesskammern, in denen die innerhalb der Prozesskammer befindlichen Halbleiterelemente mittels jeweils einer Bearbeitungsvorrichtung bearbeitet werden. Sowohl während des Bearbeitungsprozesses innerhalb der Prozesskammer, als auch während des Transfers von Prozesskammer zu Prozesskammer müssen sich die hochsensiblen Halbleiterelemente stets in geschützter Atmosphäre - insbesondere in luftleerer und partikelfreier Umgebung bzw. einer Schutzgasatmosphäre - befinden.

Die Prozesskammern sind beispielsweise über Transferkanäle miteinander verbunden. Diese Prozesskammern können mittels Vakuumtransferventilen zum Transfer der Teile von der einen zur nächsten Prozesskammer geöffnet und im Anschluss zur Durchführung des jeweiligen Fertigungsschritts gasdicht verschlossen werden. Ausserdem werden bewegliche Transferkammern verwendet, die an den Prozesskammern andocken und die Halbleiterelemente in Schutzatmosphäre zwischen den Prozesskammern transportieren können.

Aus dem Stand der Technik, beispielsweise der US 5,076,205 oder der US 5,292,393, sind Mehrkammersysteme zur Herstellung von Halbleiterelementen - insbesondere Halbleiter-Wafern - bekannt, bei welchen mehrere Prozesskammern sternförmig um eine mittige Transferkammer angeordnet sind. Die mittige Transferkammer ist über einen Tunnel mit einer zweiten Transferkammer, um welche weitere Prozesskammern sternförmig angeordnet sind, verbunden, so dass mittels einer Vielzahl derartiger Bearbeitungsinseln ein grosses zusammenhängendes Halbleiterfertigungssystem herstellbar ist. Die Halbleiterelemente werden durch ein in der Transferkammer angeordnetes Handhabungssystem von einer Prozesskammer über die Transferkammer in die nächste Prozesskammer transportiert.

Aus dem Stand der Technik sind ausserdem Vakuumkammersysteme bekannt, deren Prozesskammern entlang einer Linie angeordnet sind und vakuumdicht verschliessbare Öffnungen, die in eine gemeinsame Richtung weisen, besitzen. Eine parallel zu der Prozesskammerlinie linear verfahrbare Transferkammer ist an den einzelnen Prozesskammern andockbar und dient zum Transport der Bauteile von einer Prozesskammer zur nächsten Prozesskammer. Die evakuierte Transferkammer wird hierzu mit ihrer Transferkammeröffnung an eine Prozesskammeröffnung vakuumdicht angedockt. Ein derartiges System wird beispielsweise allgemein in der US-2007-0186851-A1 (Geiser) beschrieben.

Ausserdem ist es möglich, die Prozesskammern sequentiell in einer Aneinanderkettung von Prozesskammern anzuordnen, wobei zwischen den benachbarten Prozesskammern eine Verbindungsöffnung vorgesehen ist, welche mittels eines Transferventils gasdicht verschliessbar ist. Jede Prozesskammer weist in diesem Fall mindestens zwei Öffnungen auf, wobei die Ausgangsöffnung einer Prozesskammer jeweils die Eingangsöffnung einer in der Prozesskammerkette folgenden Prozesskammer ist. Zwischen jeweils zwei Prozesskammern und am Anfang und Ende der Prozesskammerkette befindet sich jeweils ein Transferventil, das jeweils zwei gasdicht voneinander trennbare Ventilöffnungen in seinem Ventilgehäuse aufweist.

Die beschriebenen Vakuumkammersysteme werden für unterschiedliche Bereiche der Halbleiter- und Substratfertigung eingesetzt und haben sich für die Herstellung und Bearbeitung von kleinen bis mittelgrossen Halbleiter- und Substratbauteilen bewährt. Neue technische Gebiete erfordern jedoch immer grössere einstückige Halbleiterbauteile und Substrate, die die Schaffung neuer Fertigungssysteme erfordern. Beispiele hierfür sind Solarpaneele oder Bildschirmpaneel, insbesondere Plasma- und LCD-Paneele, mit einer Breite von über einem Meter. Zur Bearbeitung derart grosser Halbleiterbauteile, Flüssigkristallsubstrate oder anderer Substrate sind entsprechend gross dimensionierte Prozesskammern und Transferventile erforderlich.

Unter einem Substrat ist allgemein im Sinne der Materialwissenschaft ein zu behandelndes Material zu verstehen, wobei insbesondere die Oberfläche des Substrats veredelt oder beschichtet wird. Es kann sich hierbei um einen Wafer aus dem Bereich der Halbleitertechnik, ein Basismaterial einer Leiterplatte oder ein sonstiges insbesondere plattenartiges oder bandartiges Material handeln, das mittels eines Beschichtungs-, Veredelungs- oder Behandlungsverfahren, das im Vakuum oder in Prozessgasumgebung stattfinden muss, entsprechend bearbeitet wird. Unter einem Substrat ist auch eine zu beschichtende Glasplatte, beispielsweise für einen Flachbildschirm oder ein Solarpaneel mit einer Dicke von unter 0,5 bis über 5 Millimeter, oder eine Edelstahlfolie oder ein Edelstahlband mit einer Dicke von unter 0,05 bis über 0,2 Millimeter zu verstehen.

Derartige Transferventile zum Öffnen und Schliessen von Prozesskammern zeichnen sich abhängig vom jeweiligen Prozess somit durch eine ausserordentlich grosse Dimensionierung, eine grosse Dichtungslänge und einen sehr grossen Öffnungsquerschnitt, zum Teil mit einer Breite von über 1000 Millimeter, aus. Die Öffnungsquerschnitte sind insbesondere langgestreckt und schlitzartig, wobei die Breite wesentlich grösser ist als die Höhe der Öffnung. Diese Ventile werden aufgrund des beschriebenen Anwendungsgebiets und der damit verbundenen Dimensionierung als Transferventile, aufgrund ihres rechteckigen Öffnungsquerschnitts auch als Rechteckventil und abhängig von ihrer Funktionsweise auch als Schieberventil, Rechteckschieber, Transferschieberventil, Klappenventil, Klappen-Transferventil oder Drehschleuse bezeichnet.

In der US 6,416,037 (Geiser) oder der US 6,056,266 (Blecha) werden klein dimensionierte Transferventile in Form von Vakuumschieberventilen oder Schieberventilen, auch Ventilschieber oder Rechteckschieber genannt, beschrieben. Das Schliessen und Öffnen erfolgt im Stand der Technik meist in zwei Schritten. In einem ersten Schritt wird ein Ventilverschluss, insbesondere ein Verschlussteller linear über eine Öffnung im Wesentlichen parallel zum Ventilsitz verschoben, ohne dass hierbei eine Berührung zwischen dem Ventilverschluss und dem Ventilsitz des Ventilgehäuses stattfindet. In einem zweiten Schritt wird der Ventilverschluss mit dessen Verschlussseite auf den Ventilsitz des Ventilgehäuses gedrückt, so dass die Öffnung gasdicht verschlossen wird. Die Abdichtung kann z.B. entweder über einen auf der Verschlussseite des Ventilverschlusses angeordneten Dichtungsring, der auf den die Öffnung umlaufenden Ventilsitz gepresst wird, erfolgen, oder über einen Dichtungsring auf dem Ventilsitz, gegen den die Verschlussseite des Ventilverschlusses gedrückt wird.

Ausserdem sind kleinere Schieberventile bekannt, bei welchen der Schliess- und Dichtvorgang über eine einzige lineare Bewegung erfolgt. Ein solches Ventil ist beispielsweise das unter der Produktbezeichnung "MONOVAT Reihe 02 und 03" bekannte und als Rechteckinsertventil ausgestaltete Transferventil der Firma VAT Vakuumventile AG in Haag, Schweiz. Der Aufbau und die Funktionsweise eines solchen Ventils werden beispielsweise in der US 4,809,950 (Geiser) und der US 4,881,717 (Geiser) beschrieben.

Derartige Antriebstechniken haben sind im Stand der Technik bewährt, sie eignen sich jedoch nur bedingt für sehr grosse Öffnungsquerschnitte, insbesondere langgestreckte, schlitzartige Öffnungsquerschnitte.

Aufgrund der sich durch den grossen Öffnungsquerschnitt ergebenden grossen Dichtungslängen sind die Anforderungen an die Dichtungen, die Führung des Ventilverschlusses sowie den Antrieb sehr hoch.

Unterschiedliche Dichtvorrichtungen sind aus dem Stand der Technik bekannt, beispielsweise aus der US 6,629,682 B2 (Duelli). Ein geeignetes Material für Dichtungsringe ist beispielsweise das unter dem Handelsnamen Viton® bekannte elastische Dichtungsmaterial.

Bei derart grossen Dichtungslängen und Öffnungsquerschnitten besteht eine besondere Herausforderung darin, über die gesamte Dichtungslänge selbst bei sehr grossen Druckdifferenzen die Dichtigkeit zu gewährleisten. Das Dichtungsverhalten der zum Einsatz kommenden Dichtungen ist meist auf einen sehr geringen Bereich begrenzt. Überschreitet der Abstand zwischen dem Ventilverschluss und dem Ventilsitz einen bestimmten Grenzwert, ist die Anpresskraft der Dichtung auf den Ventilsitz zu gering und die Dichtigkeit ist nicht mehr gewährleistet. Ist hingegen der Abstand zwischen dem Ventilverschluss und dem Ventilsitz zu gering und somit die Anpresskraft der Dichtung auf den Ventilsitz zu gross, unterliegt die Dichtung einem erheblichen Verschleiss und wird unter Umständen zerstört. Aus diesem Grunde ist im geschlossenen Zustand des Ventils selbst bei grossen Druckdifferenzen stets ein gewisser Anpressdruck der Dichtung auf den Ventilsitz über die gesamte Länge der Dichtung einzuhalten. Dieser gewisse Anpressdruck ist auf einen relativ kleinen Bereich begrenzt.

Vor allem bei gross dimensionierten Ventilen, insbesondere mit einem ausgeprägten asymmetrischen Querschnitt, beispielsweise einer langgestreckten, schlitzartigen Öffnung, ist die Einhaltung eines konstanten Anpressdrucks bei grösseren Druckdifferenzen problematisch. Zur Einhaltung eines konstanten Anpressdrucks sehen bestimmte Transferventile eine besonders robuste Dimensionierung des Ventilverschlusses und dessen Antriebs sowie dessen Lagerung vor, so dass der Ventilverschluss selbst bei hohen Kräften, die aufgrund der Druckdifferenz auf den Ventilverschluss wirken, seine Sollstellung behält und nicht ungewollt seine Position verändert. Eine möglichst stabile und unelastische Ausbildung des Ventilverschlusses und dessen Antriebs- und Lagerungskomponenten erscheint zunächst nahe liegend zu sein. Ein weiteres Problem besteht jedoch nicht nur im allfällig elastischen Verhalten des Ventilverschlusses und dessen Peripherie. Im Falle gross dimensionierter Prozesskammern führen die Druckdifferenzen zwischen dem Kammerinneren und der Umgehung oder zwischen zwei Kammern zu einer Verformung der gesamten Kammerwand. Das an der Kammerwand angeordnete und mit dieser gekoppelte Transferventil unterliegt ebenfalls dieser Verformung der Kammerwand. Da sich der mit der Kammerwand gekoppelte Ventilsitz entsprechend der Wölbung der Kammerwand verformt, ist bei einem unverformten Ventilverschluss kein konstanter Anpressdruck der Dichtung entlang der Dichtungslänge gewährleistet.

Ein weiteres Problem besteht darin, dass es im Falle einer Verformung der Kammerwand zu Schwerkräften zwischen der Dichtung und dem Ventilsitz kommen kann. In anderen Worten wird die Dichtung quer zur Anpresskraft belastet. Eine derartige, scherende Querbelastung führt zu einem erheblichen Verschleiss der Dichtung oder sogar zu einer Zerstörung der Dichtung, so dass die geforderte Gasdichtigkeit nicht mehr gewährleistet ist.

In der EP 0 554 522 A2 wird eine Drehschleuse zum Ein-und/oder Ausbringen eines Substrats von der einen in eine benachbarte Behandlungskammer oder aus dem atmosphärischen Raum in eine Kammer geringeren Drucks, insbesondere Schlitzschleuse für eine Durchlauf-Vakuumbeschichtungsanlage mit einer klappenartigen, in ortsfesten Lagern gehaltenen Ventilplatte und zwei mit dieser in Wirkverbindung stehenden Schliessmotoren beschrieben. Die Ventilplatte ist unter Zwischenschaltung zweier federnder Stäbe an einem Ventilbalken angelenkt, der seinerseits zwei einander diametral gegenüberliegende Lagerzapfen aufweist, die drehfest mit den Wellen der Motoren gekuppelt sind, wobei die Wellen der Motoren durch die Wand der Kammer druckfest hindurchgeführt sind. Die Befestigung der Ventilplatte am Ventilbalken mit Hilfe von zwei Federstäben soll eine in zwei Achsen zueinander bewegliche, gelenk- und damit reibungsfreie Verbindung darstellen, mit der verhindert werden soll, dass die bei der Ventilbetätigung auftretenden Relativbewegungen zwischen der Ventilplatte und dem Ventilbalken zueinander eine Gelenkreibung und damit auch Abriebpartikel erzeugen. Die Federstäbe sind an der Ventilplatte und dem Ventilbalken in der Weise angeordnet, dass sie mit Hilfe besonderer Klemmstücke in entsprechende V-förmig ausgefräste Nuten gedrückt werden. Diese V-Nuten sind so ausgebildet, dass bei ungespannten Federstäben die Ventilplatte eine definiert nicht parallele Lage zum Ventilbalken einnimmt, so dass beim Schliessvorgang die Ventilplattendichtfläche sowohl auf den O-Ring aussen als auch auf den O-Ring innen zum gleichen Zeitpunkt aufsetzt. Mittels dieser Anordnung soll gewährleistet sein, dass die Dichtung geschont wird und über die ganze Länge der Ventilplatte eine gleichmässige Schliesskraft bzw. Anpresskraft erzeugbar ist. Im Wartungs-und Reparaturfall sollen die Druckstufe und die Antriebseinheit problemlos auswechselbar sein, während die vergleichsweise sperrige und schwere Ventileinheit komplett montiert im Rezipienten verbleibt. Ein Nachteil der beschriebenen Drehschleuse besteht darin, dass beim Anpressen der Dichtung auf den Ventilsitz aufgrund der nicht parallelen Lage der Ventilplatte zum Ventilbalken sowie im Falle einer Verformung der Wand zwangsläufig eine gewisse scherende Querbelastung der Dichtung stattfindet.

Die Notwendigkeit einer möglichst konstanten Anpresskraft entlang der Dichtungslänge der Dichtung eines Transferventils, selbst bei unvermeidbaren elastischen Verformungen des Ventilsitzes und des Ventilverschlusses, wie sie vor allem bei langgestreckten, insbesondere schlitzartigen Öffnungsquerschnitten auftreten, sowie die Vermeidung einer ungleichmässigen Belastung oder einer Querbelastung der Dichtung stellt ein bisher nicht hinreichend gelöstes Problem im Stand der Technik dar.

Der vorliegenden Erfindung liegt daher die Aufgabe zugrunde, ein Transferventil, das eine langgestreckte, insbesondere schlitzartige erste Öffnung aufweist, so auszubilden, dass sowohl beim Anpressen der Dichtung auf den Ventilsitz, als auch bei Verformung der Ventilwand eine übermässige Belastung der Dichtung sowie die Erzeugung von prozessschädlichen Partikeln vermieden wird.

Diese Aufgabe wird durch die Verwirklichung der Merkmale des unabhängigen Anspruchs gelöst. Merkmale, die die Erfindung in alternativer oder vorteilhafter Weise weiterbilden, sind den abhängigen Patentansprüchen zu entnehmen.

Das erfindungsgemässe Klappen-Transferventil für den Transfer von Halbleiterelementen oder Substraten in eine gasdicht isolierbare Halbleiter- oder Substratbearbeitungs-Prozesskammer hat eine langgestreckte, insbesondere schlitzartige ersten Öffnung, die sich entlang einer geometrischen ersten Längsachse erstreckt und die von einer ersten Dichtfläche rahmenförmig umschlossen ist. Die erste Dichtfläche liegt in einer geometrischen ersten Dichtebene. Unter langgestreckt und schlitzartig ist zu verstehen, dass die Breite der insbesondere rechteckigen ersten Öffnung entlang ihrer ersten Längsachse mindestens das Doppelte oder Dreifache, insbesondere das Vierfache, Fünffache, Sechsfache, Achtfache, Zehfache oder Zwölffache der Höhe der ersten Öffnung senkrecht zur ersten Längsachse beträgt. Die Breite der ersten Öffnung beträgt beispielsweise über 500 Millimeter, insbesondere über 800 Millimeter, im Speziellen über 1000 Millimeter. Die erste Längsachse erstreckt sich entlang der Breite der Öffnung und verläuft senkrecht zu der Öffnungsachse, welche die Normale zum Öffnungsquerschnitt bildet.

Um die erste Öffnung gasdicht verschliessen zu können, ist ein langgestreckter Ventilverschlussbalken vorgesehen. Der langgestreckte Ventilverschlussbalken hat vorzugsweise einen rechteckigen Querschnitt, der mit dem vorzugsweise rechteckigen Querschnitt der ersten Öffnung korrespondiert und die erste Öffnung ringsum überlappt, so dass mittels des Ventilverschlussbalkens die erste Öffnung vollständig überdeckt werden kann. Die genannten Breiten- und Höhenverhältnisse der ersten Öffnung gelten somit auch für den Ventilverschlussbalken. Der Ventilverschlussbalken erstreckt sich entlang einer zur ersten Längsachse im Wesentlichen parallelen geometrischen zweiten Längsachse. In anderen Worten erstreckt sich die zweite Längsachse entlang der Breite des Ventilverschlussbalkens und verläuft parallel zur ersten Längsachse. Unter einem Ventilverschlussbalken ist allgemein ein langgestreckter Ventilverschluss zu verstehen, insbesondere ein breiter Ventilteller. Der Ventilverschlussbalken besitzt eine Vorderseite und eine Rückseite. Mittels der zur ersten Öffnung weisenden Vorderseite kann die erste Öffnung verschlossen werden. Hierzu sind auf der Vorderseite eine Verschlussfläche zum Verschliessen der ersten Öffnung und eine mit der ersten Dichtfläche korrespondierende und mit ihr in gasdichten Kontakt bringbare zweite Dichtfläche vorgesehen. Diese zweite Dichtfläche befindet sich im Randbereich der Verschlussfläche und liegt in einer geometrischen zweiten Dichtebene. In anderen Worten kann durch im Wesentlichen senkrechtes Aufdrücken des Ventilverschlussbalkens mit dessen zweiten Dichtfläche ein gasdichter Kontakt mit der ersten Dichtfläche, welche rings um die erste Öffnung verläuft, hergestellt werden, wobei im Falle dieses gasdichten Kontakts die erste Dichtfläche und die zweite Dichtfläche parallel sind und in einer gemeinsamen Ebene aufeinander liegen.

In einer möglichen Ausführungsform ist die erste Dichtfläche rings um die erste Öffnung ein insbesondere ebener Ventilsitz. Die zweite Dichtfläche wird von einer beispielsweise elastischen Dichtung, insbesondere einem O-Ring, gebildet, die auf der Vorderseite des Ventilverschlussbalkens auf dessen Verschlussfläche angeordnet ist. Die Dichtung kann jedoch auch von der ersten Dichtfläche gebildet werden. In anderen Worten kann sich die elastische Dichtung entweder auf dem Ventilverschlussbalkens oder im Randbereich der ersten Öffnung befinden.

Auf der Rückseite des Ventilverschlussbalkens befindet sich mindestens eine Abstützung, auf welcher der Ventilverschlussbalken montiert ist und die den Ventilverschlussbalken abstützt. Die Abstützung dient dazu, den Ventilverschlussbalken abzustützen sowie eine Kraft auf die Rückseite des Ventilverschlussbalkens einleiten und somit den Ventilverschlussbalken verstellen zu können.

Die Abstützung ist mit einer Schwenklagerung gekoppelt. Mittels der Schwenklagerung sind die Abstützung und der daran angeordnete Ventilverschlussbalken um eine zur zweiten Längsachse des Ventilverschlussbalkens und somit auch zur ersten Längsachse der ersten Öffnung im Wesentlichen parallele geometrische Schwenkachse zwischen einer Geschlossenstellung und einer Offenstellung schwenkbar.

In der Geschlossenstellung überdeckt der Ventilverschlussbalken mit seiner Verschlussfläche die erste Öffnung und verschliesst die erste Öffnung gasdicht, wobei die erste Dichtfläche und die zweite Dichtfläche in gasdichtem Kontakt zueinander stehen. In anderen Worten ist der Ventilverschlussbalken in der Geschlossenstellung auf die erste Öffnung geschwenkt und verschliesst diese. Der gasdichte Kontakt wird durch Ausüben einer mittels der Abstützung auf die Rückseite aufgebrachten Kraft hergestellt und aufrecht gehalten. In dieser Geschlossenstellung liegen die erste Dichtebene der ersten Dichtfläche der ersten Öffnung und die zweite Dichtebene der zweiten Dichtfläche des Ventilverschlussbalkens aufeinander.

In der Offenstellung ist der Ventilverschlussbalken von der ersten Öffnung weggeschwenkt. Der Ventilverschlussbalken gibt die erste Öffnung somit frei. Vorzugsweise ist der Ventilverschlussbalken in der Offenstellung vollständig aus der Projektion des Öffnungsquerschnitts geschwenkt, so dass ein ungehinderter Transfer von Substraten und Halbleiterelementen durch die erste Öffnung erfolgen kann. Der Schwenkwinkel des Ventilverschlussbalkens zwischen der Offenstellung und der Geschlossenstellung beträgt vorzugsweise etwa 90 Grad, insbesondere zwischen 60 und 105 Grad. Es ist jedoch auch möglich, dass der Ventilverschlussbalken in der Offenstellung mit einem nur sehr kleinen Schwenkwinkel von beispielsweise zwischen 5 und 30 Grad, von der Geschlossenstellung weggeschenkt ist und in Form einer weiteren Bewegung, beispielsweise einer Querbewegung zur Schwenkachse, quer aus dem Öffnungsquerschnitt herausbewegt wird, beispielsweise mittels einer Linearbewegung parallel zur ersten Dichtebene oder einer weiteren Schwenkbewegung, wobei die weitere Schwenkachse im Wesentliche eine Normal zur ersten Dichtebene bildet.

Unter der Schwenklagerung ist allgemeine funktional eine Lagerung zu verstehen, welche ein Schwenken des Ventilverschlussbalkens um die geometrische Schwenkachse ermöglicht. Mittels welcher strukturellen Merkmale eine derartige Schwenklagerung umsetzbar ist, wird im Folgenden sowie in den Ausführungsbeispielen näher beschrieben.

Zwischen dem Ventilverschlussbalken und der Abstützung besteht eine schwenkbare Verbindung, die derart ausgebildet ist, dass der Ventilverschlussbalken relativ zur Abstützung um eine geometrische Kippachse schwenkbar ist. Diese Kippachse verläuft parallel zur zweiten Längsachse und auch parallel zur Schwenkachse, um welche die Abstützung und der Ventilverschlussbalken gemeinsam mittels der Schwenklagerung zwischen der Geschlossenstellung und der Offenstellung schwenkbar sind. Vorzugsweise verläuft die Kippachse mittig im Ventilverschlussbalken zwischen der wirksamen zweiten Dichtfläche. Der Schwenkwinkel, um welchen der Ventilverschlussbalken relativ zur Abstützung schwenkbar ist, ist begrenzt.

Erfindungsgemäss liegt die Schwenkachse, um welche die Abstützung und der Ventilverschlussbalken gemeinsam mittels der Schwenklagerung zwischen der Geschlossenstellung und der Offenstellung schwenkbar sind, im Wesentlichen in der ersten Dichtebene der ersten Dichtfläche der ersten Öffnung. In einer speziellen Ausführungsform liegt diese geometrische Schwenkachse in der geometrischen ersten Dichtebene. Ebenfalls erfindungsgemäss liegt die Kippachse, um welche der Ventilverschlussbalken relativ zur Abstützung mit dem begrenzten Schwenkwinkel schwenkbar ist, im Wesentlichen in der zweiten Dichtebene der zweiten Dichtfläche des Ventilverschlussbalkens. In einer speziellen Ausführungsform liegt die geometrische Kippachse in der geometrischen zweiten Dichtebene.

Aufgrund dieser speziellen Anordnung liegen sowohl die Schwenkachse, als auch die Kippachse in der Geschlossenstellung in einer gemeinsamen Ebene, nämlich in der aufeinander liegenden ersten Dichtebene und zweiten Dichtebene. Hierdurch wird erreicht, dass sich beim Aufsetzen des Ventilverschlussbalkens mit dessen zweiten Dichtfläche auf die erste Dichtfläche der ersten Öffnung kurz vor Erreichen der Geschlossenstellung, wobei sich die erste Dichtebene und die zweite Dichtebene in leicht schiefer Ausrichtung zueinander befinden können, während des Andrückens des Ventilverschlussbalkens auf die erste Dichtfläche im Wesentliche keine scherende Querbelastung auf den Dichtkontakt zwischen der ersten Dichtfläche und der zweiten Dichtfläche ergibt. Der Ventilverschlussbalken wird im Wesentlichen senkrecht auf die erste Dichtfläche gedrückt.

In anderen Worten bewirkt die erfindungsgemässe Anordnung der Schwenkachse und der Kippachse, dass beim Übergang der ersten Dichtfläche und zweiten Dichtfläche von der fast geschlossenen Stellung in die Geschlossenstellung im Wesentlichen keine Querverschiebung der Dichtflächen zueinander stattfindet. Somit werden die Dichtflächen geschont, die Lebensdauer der Dichtflächen erhöht und die Partikelgenerierung durch Abrieb an den Dichtflächen vermieden.

Ein weiterer Effekt der Erfindung besteht darin, dass bei hoher Belastung des Klappen-Transferventils aufgrund grosser Druckdifferenzen und somit erfolgender Verformung der Wand um die erste Öffnung, der ersten Dichtfläche und/oder des Ventilverschlussbalkens ein weiteres Schwenken des Ventilverschlussbalkens und der Abstützung um die Schwenkachse mittels der Schwenklagerung im Wesentlichen zu keiner Querbewegung zwischen der ersten Dichtfläche und der zweiten Dichtfläche führt, da der Ventilverschlussbalken im Wesentlichen senkrecht auf die erste Dichtfläche ohne nennenswerte Querbewegung gedrückt wird.

Die schwenkbare Verbindung zwischen der Abstützung und dem Ventilverschlussbalken kann von mindestens einem Kippgelenk, mindestens einem Kugelgelenk und/oder mindestens einem Schwenkgelenk und/oder mindestens einem sonstigen Gelenk gebildet werden, das zumindest einen rotatorischen Freiheitsgrad um die Kippachse ermöglicht. Unter der schwenkbaren Verbindung ist allgemein funktional eine um die Kippachse schwenkbare Kopplung zwischen dem Ventilverschlussbalken und der Abstützung zu verstehen.

Vorzugsweise ist die im Randbereich der Verschlussfläche liegende zweite Dichtfläche in Richtung zur Rückseite des Ventilverschlussbalkens derart zurückversetzt, dass die Verschlussfläche des Ventilverschlussbalkens zumindest in einem mittleren Bereich des Ventilverschlussbalkens über die zweite Dichtebene in Richtung der Vorderseite des Verschlussbalkens hinausragt. In anderen Worten erstreckt sich der Ventilverschlussbalken in dem mittleren Bereich, der zwischen der randseitigen zweiten Dichtfläche liegt und von dieser umgeben und eingeschossen ist, über die zweite Dichtebene hinaus in Richtung zur ersten Öffnung, ragt in der Geschlossenstellung in die erste Öffnung hinein und über die erste Dichtebene der ersten Öffnung hinaus. Auf der Rückseite des Ventilverschlussbalkens, zumindest in dem mittleren Bereich des Ventilverschlussbalkens, ist eine Ausnehmung ausgeformt, die sich mindestens bis zur zweiten Dichtebene in Richtung zur Vorderseite und somit in Richtung zur ersten Öffnung erstreckt. Die Ausnehmung stellt allgemein eine nicht bis zur Vorderseite durchgehende Vertiefung auf der Rückseite des Ventilverschlussbalkens dar, deren Tiefe bis zur geometrischen zweiten Dichtebene reicht. Die geometrische Kippachse durchläuft den Bereich der Ausnehmung. Die schwenkbare Verbindung zwischen dem Ventilverschlussbalken und der Abstützung, insbesondere das mindestens eine Kippgelenk, Kugelgelenk, Schenkgelenk oder sonstige Gelenk, ist in der Ausnehmung des Ventilverschlussbalkens angeordnet.

Gemäss einem weiteren Aspekt der Erfindung wird die schwenkbare Verbindung von der mindestens einen Ausnehmung und mindestens einem Vorsprung der Abstützung gebildet. Der Vorsprung und die Ausnehmung sind derart ausgebildet und angeordnet, dass der Vorsprung in die Ausnehmung hineinragt und ein derartiger Kontakt zwischen dem Vorsprung und der Ausnehmung besteht, dass der Ventilverschlussbalken relativ zur Abstützung um die Kippachse schwenkbar ist. Unter dem Vorsprung ist allgemein ein Abschnitt der Abstützung zu verstehen, der in die Ausnehmung einfühbar ist und durch Kontakt mit der Ausnehmung eine schwenkbare Verbindung bildet. Dies kann beispielsweise ein Keil-, Zapfen-, Stift-, Bolzen-, Kugel-, Kegel- oder Zylinderabschnitt sein, wobei die Ausnehmung eine hierzu im Wesentlichen korrespondierende Form aufweist.

In einer Weiterbildung der Erfindung ist die schwenkbare Verbindung als Kippgelenk ausgebildet. Der bevorzugte Aufbau dieses Kippgelenks wird im Folgenden erläutert. Die Ausnehmung weist einen Boden auf. Hierunter ist vorzugsweise der Punkt, die Linien oder die Fläche der Ausnehmung zu verstehen, die am tiefsten ist, also die der Vorderseite am nächsten ist. Der Vorsprung weist in Bezug zu der geometrischen Ebene, die von der Kippachse und der zweiten Längsachse senkrecht durchstossen wird, einen spitz zusammenlaufenden Querschnitt mit einer Spitze auf. Zwischen dieser Spitze und dem Boden besteht ein auf der Kippachse liegender punktförmiger oder linienförmiger Kontakt, der das Kippgelenk bildet. In anderen Worten liegt eine im Wesentlichen punktförmige oder entlang der Kippachse linienförmige Spitze des Vorsprungs auf dem Boden der Ausnehmung auf. Das Schwenken um die Kippachse erfolgt um diese Spitze herum.

Der Vorsprung hat insbesondere einen V-förmigen Querschnitt und die Spitze des Vorsprungs wird von dem spitz zusammenlaufenden V-Winkel des Querschnitts gebildet. Die Form des Vorsprungs kann demnach insbesondere spitzkegelartig oder keilartig sein, wobei die Spitze im Wesentlichen von einem Punkt, der von der Kippachse im Wesentlichen durchlaufen wird, bzw. einer sich zumindest teilweise entlang der Kippachse erstreckenden Linie gebildet wird.

Die Ausnehmung hat insbesondere einen in Bezug zu der geometrischen Ebene, die von der Kippachse und der zweiten Längsachse senkrecht durchstossen wird, einen nach innen zusammenlaufenden, insbesondere konkaven Querschnitt. Beispielsweise hat die Ausnehmung einen V-förmigen Querschnitt. Der Boden wird hierbei von dem stumpf zusammenlaufenden V-Winkel gebildet. Vorzugsweise ist die Ausnehmung als eine sich zumindest teilweise entlang der Kippachse erstreckende Nut ausgebildet, wobei der Boden der Nut in der zweiten Dichtebene verläuft. Der Vorsprung ist in diesem Fall vorzugsweise als ein sich entlang der Kippachse erstreckender Keil ausgebildet.

Haben sowohl die Ausnehmung, als auch der Vorsprung einen V-förmigen Querschnitt, ist der V-Winkel der Ausnehmung vorzugsweise grösser als der V-Winkel des Vorsprungs, so dass der Vorsprung mit dessen Spitze vollständig in die Ausnehmung geführt werden kann und im zusammenlaufenden Boden der Ausnehmung zum Liegen kommt.

Diese erfindungsgemässe Kipplagerung hat mehrere wesentliche Vorteile. Aufgrund des punkt- oder linienartigen Kontakts zwischen dem Vorsprung und der Ausnehmung wird die Kontaktfläche des Lagers minimiert. Durch die kleine Kontaktfläche ergibt sich auch eine kleine Reibfläche, was wiederum dazu führt, dass die durch Reibung bedingte Partikelgenerierung minimiert wird. Die erfindungsgemässe Lagerung des Ventilverschlussbalkens auf der Abstützung verursacht somit kaum prozessschädliche Partikel. Ein weiterer Vorteil der erfindungsgemässen Lagerung besteht darin, dass die Kippachse auf die zweite Dichtebene gelegt werden kann, ohne dass die Ausnehmung zwangsläufig über die zweite Ausnehmung hinausragen muss. Die erfindungsgemässe Lagerung ermöglicht somit einen flachen und kompakten Aufbau des Ventilverschlussbalkens. Ausserdem zeichnet sich die erfindungsgemässe Lagerung durch Wartungsfreundlichkeit und Verschleissarmut aus.

In einer Weiterbildung der Erfindung befindet sich eine Federanordnung zwischen dem Ventilverschlussbalken und der Abstützung. Diese Federanordnung ist derart angeordnet, dass der Ventilverschlussbalken auf der Abstützung gehalten und der Vorsprung in die Ausnehmung in Richtung senkrecht zur zweiten Dichtebene gedrückt wird. Die Federanordnung wird beispielsweise von mindestens einer auf der Rückseite des Ventilverschlussbalkens angeordneten Blattfeder gebildet, die quer zur Kippachse hinter dem in die Ausnehmung hineinragenden Vorsprung angeordnet ist, so dass die Federanordnung den Vorsprung in die Ausnehmung in Richtung senkrecht zur zweiten Dichtebene drückt.

Um den Schwenkwinkel des Ventilverschlussbalkens relativ zur Abstützung um die Kippachse definiert zu begrenzen, sieht die Erfindung ausserdem einen den Schwenkwinkel begrenzenden Schwenkanschlag zwischen dem Ventilverschlussbalken und der Abstützung vor. Mindestens eine Feder zwischen dem Ventilverschlussbalken und der Abstützung drückt in der Offenstellung bzw. in einer Stellung des Ventilverschlussbalkens, in welcher dieser nicht auf die erste Dichtfläche gedrückt ist, den Ventilverschlussbalken an den Schwenkanschlag, so dass dieser eine definierte Grundstellung einnimmt. In dieser definierten Grundstellung ist der Ventilverschlussbalken in der Offenstellung gegenüber der Abstützung derart verkippt ist, dass beim Schwenken der Abstützung und des Ventilverschlussbalkens mittels der Schwenklagerung von der Offenstellung in die Geschlossenstellung beim Herstellen des ersten Kontakts zwischen ersten Dichtfläche und der zweiten Dichtfläche diese Dichtflächen eben aufeinander zum Liegen kommen. Mindestens eine der Dichtflächen ist vorzugsweise elastisch ausgebildet. Das heisst, dass zwischen dem ersten Kontakt der Dichtflächen, wobei die Dichtflächen unverpresst zumindest in einem Teilabschnitt aufeinander zum Liegen kommen, und der Geschlossenstellung, in welcher die beiden Dichtflächen derart miteinander verpresst sind, dass ein gasdichter Kontakt hergestellt ist, ein gewisser Schwenkwinkel, im Folgenden Verpressschwenkwinkel genannt, besteht. In einer bevorzugten Ausbildung der Erfindung ist der Ventilverschlussbalken in der Grundstellung um diesen Verpressschwenkwinkel um die Kippachse verkippt. Dies bewirkt, dass während des Schliessvorgangs beim Herstellen des ersten Kontakts zwischen den Dichtflächen die zweite Dichtfläche parallel zur ersten Dichtfläche ausgerichtet ist, so dass die Dichtflächen gleichmässig und eben aufeinander zum Liegen kommen. Aufgrund der erfindungsgemässen Anordnung der Kippachse und der Schwenkachse kommt es während des weiteren Verpressens der Dichtflächen zu keiner wesentlichen Querbelastung der Dichtflächen in eine Richtung parallel zu den Dichtebenen.

Ein weiterer Aspekt der Erfindung beinhaltet, dass neben der ersten Öffnung eine sich parallel zur ersten Längsachse der ersten Öffnung und entlang der Schwenkachse erstreckende Schwenkwelle angeordnet ist, an welcher die Abstützung zum Schwenken um die Schwenkachse befestigt ist. Beispielsweise ist die Schwenkwelle drehbar an der die erste Öffnung beinhaltenden Wand des Ventilgehäuses des Klappen-Transferventils gelagert. An der Schwenkwelle kann drehfest mindestens ein sich zumindest teilweise senkrecht zur Schwenkachse erstreckender Arm angeordnet sein, an welchem die Abstützung mittelbar oder unmittelbar fixiert ist. Diese Schwenkwelle kann lediglich eine Lagerfunktion haben, so dass der Ventilverschlussbalken um die Schwenkachse schwenkbar gelagert ist, oder auch eine Antriebsfunktion zum Schwenken des Ventilverschlussbalkens.

Aus dem Stand der Technik sind unterschiedliche Möglichkeiten bekannt, mittels einer Schwenklagerung und eines geeigneten Antriebs einen Ventilverschlussbalken eines Klappen-Transferventils zwischen einer Offenstellung und einer Geschlossenstellung zu schwenken. Eine Möglichkeit besteht darin, die oben genannte Schwenkwelle direkt mittels eines Antriebs drehbar anzutreiben. Ein derartiger Antrieb wird beispielsweise in der EP 0 554 522 beschrieben. Ein Vorteil eines solchen Antriebs besteht im einfachen Aufbau. Nachteilig ist jedoch, dass aufgrund des grossen Hebelarms ein sehr hohes Drehmoment auf die Schwenkwelle wirkt und vor allem bei grossen Dichtflächen und grossen Druckdifferenzen Torsionen und elastische Verformungen der Arme unvermeidbar sind, so dass bei bestimmten Anwendungen die geforderte Gasdichtigkeit nicht mehr gewährleistet ist.

Ein weiterer Aspekt der Erfindung umfasst daher, dass das beschriebene Klappen-Transferventil eine Welle aufweist, die um eine zur zweiten Längsachse im Wesentlichen parallele Wellenachse, die von der Schwenkachse insbesondere in Richtung senkrecht zur ersten Dichtebene beabstandet ist und auf der Rückseite des Ventilverschlusstellers liegt, drehbar ist. Mindestens ein Antrieb ist mit der Welle zum Drehen dieser Welle um die Wellenachse und Verstellen des Ventilverschlussbalkens zwischen der Offenstellung und der Geschlossenstellung gekoppelt. Zwischen der Welle und der Abstützung befindet sich mindestens ein an der Welle drehfest angeordneter erster Arm. Das freie Ende des ersten Arms steht direkt oder indirekt über die Abstützung mit der Rückseite des Ventilverschlussbalkens derart in Eingriff, dass durch Drehen der Welle und somit durch Schwenken des ersten Arms um die Wellenachse eine Kraft auf die Rückseite des Ventilverschlussbalkens zum Schwenken des Ventilverschlussbalkens um die Schwenkachse zwischen der Offenstellung und der Geschlossenstellung aufbringbar ist.

In anderen Worten besitzt das Klappen-Transferventil beispielsweise eine Welle, die um ihre sich längs der Welle zentrisch erstreckende Wellenachse drehbar gelagert ist. Die Wellenachse verläuft zur zweiten Längsachse des Ventilverschlussbalkens und somit auch zur ersten Längsachse der ersten Öffnung im Wesentlichen parallel. Diese Welle steht in derartiger Wirkverbindung zu dem Ventilverschlussbalken, dass ein Drehen der Welle um die Wellenachse ein Schwenken des Ventilverschlussbalkens um die Schwenkachse bewirkt. Mindestens ein Antrieb ist mit der Welle zum Drehen der Welle um die Wellenachse gekoppelt. Aufgrund der Wirkverbindung der Welle mit dem Ventilverschlussbalken wird durch das Verdrehen der Welle der Ventilverschlussbalkens zwischen der Offenstellung und der Geschlossenstellung verstellt. Bei dem Antrieb kann es sich beispielsweise um einen Drehantrieb, dessen erzeugte Drehbewegung direkt oder indirekt zu einer Drehbewegung der Welle führt, oder einen Linearantrieb, dessen Axialbewegung insbesondere mittels eines an der Welle direkt oder indirekt angeordneten Hebels in eine Drehbewegung der Welle umgewandelt wird, handeln.

Die Erfindung sieht in einer Weiterbildung vor, dass der Ventilverschlussbalken, die Abstützung, die Schwenklagerung und die Welle in einem Ventilgehäuse angeordnet sind. Die erste Öffnung ist auf einer ersten Öffnungsseite des Ventilgehäuses angeordnet. Eine der ersten Öffnung gegenüberliegende zweite Öffnung ist auf einer der ersten Öffnungsseite gegenüberliegenden zweiten Öffnungsseite des Ventilgehäuses angeordnet.

In einer möglichen Ausführungsform liegt der ersten Öffnung die zweite Öffnung im Ventilgehäuse gegenüber. Die Öffnungen verbinden jeweils das Innere des Ventilgehäuses mit dem Äusseren des Ventilgehäuses, wobei zumindest die erste Öffnung durch das Schliessen mittels des Ventilverschlussbalkens schliessbar und somit die diesbezügliche Verbindung des Ventilinneren mit dem Ventiläusseren trennbar ist. Die der äusseren ersten Öffnungsseite gegenüberliegende äussere Seite des Ventilgehäuses wird als die zweite Öffnungsseite des Ventilgehäuses bezeichnet. Unter gegenüberliegend ist nicht zwangsläufig eine exakte geometrische Gegenüberlage zu verstehen, sondern allgemein, dass die erste Öffnungsseite und die zweite Öffnungsseite in unterschiedliche Richtungen weisen. Es ist jedoch auch möglich, dass das Ventilgehäuse keine derartige zweite Öffnung aufweist.

In einer Weiterbildung der Erfindung ist dem mindestens einen ersten Arm jeweils ein zweiter Arm zugeordnet, der auf der Rückseite des Ventilverschlussbalkens auf der Abstützung um eine zweite Armachse, die parallel zur Schwenkachse verläuft, schwenkbar gelagert ist. Jeweils der erste Arm und der zweite Arm sind an ihren freien Enden um eine zur zweiten Armachse im Wesentlichen parallele erste Armachse gelenkig miteinander verbunden. Die Welle, der erste Arm und der zweite Arm bilden somit einen Hebelantrieb, insbesondere einen Kniehebel- oder Spannhebelmechanismus. Vorzugsweise sind die Längen des ersten Arms und des zweiten Arms und die Abstände der Wellenachse, der ersten Armachse und der zweiten Armachse derart, dass die Wellenachse, die erste Armachse und die zweite Armachse in der Geschlossenstellung im Wesentlichen in einer gemeinsamen Ebene liegen und sich der erste Arm und der zweite Arm im Wesentlichen in Totpunktausrichtung befinden. Aufgrund dieser Totpunktausrichtung wird in der Geschlossenstellung kein Drehmoment im Falle einer Druckdifferenz am Ventilverschlussbalken ausgeübt, so dass es zu keiner Torsion der Welle kommt.

Die erfindungsgemässe Vorrichtung und das erfindungsgemässe Verfahren werden nachfolgend anhand von in den Zeichnungen schematisch dargestellten konkreten Ausführungsbeispielen rein beispielhaft näher beschrieben.

Im Einzelnen zeigen:
- Fig. 1a: eine seitliche Querschnittsansicht auf ein Ausführungsbeispiel des Klappen-Transferventils in einer Geschlossenstellung des Ventilverschlussbalkens;
- Fig. 1b: eine seitliche Querschnittsansicht auf das Ausführungsbeispiel des Klappen-Transferventils in einer Offenstellung des Ventilverschlussbalkens;
- Fig. 1c: eine Schrägansicht auf die Rückseite des Ventilverschlussbalkens;
- Fig. 1d: eine detaillierte Schrägansicht auf die schwenkbare Verbindung auf der Rückseite des Ventilverschlussbalkens;
- Fig. 1e: eine Schrägansicht auf das Ausführungsbeispiel des Klappen-Transferventils;
- Fig. 2: eine seitliche Querschnittsansicht auf eine erstes alternatives Ausführungsbeispiel des Klappen-Transferventils in einer Geschlossenstellung des Ventilverschlussbalkens;
- Fig. 3: eine seitliche Querschnittsansicht auf eine zweites alternatives Ausführungsbeispiel des Klappen-Transferventils in einer Geschlossenstellung des Ventilverschlussbalkens; und
- Fig. 4: eine seitliche Querschnittsansicht auf eine drittes alternatives Ausführungsbeispiel des Klappen-Transferventils in einer Geschlossenstellung des Ventilverschlussbalkens.

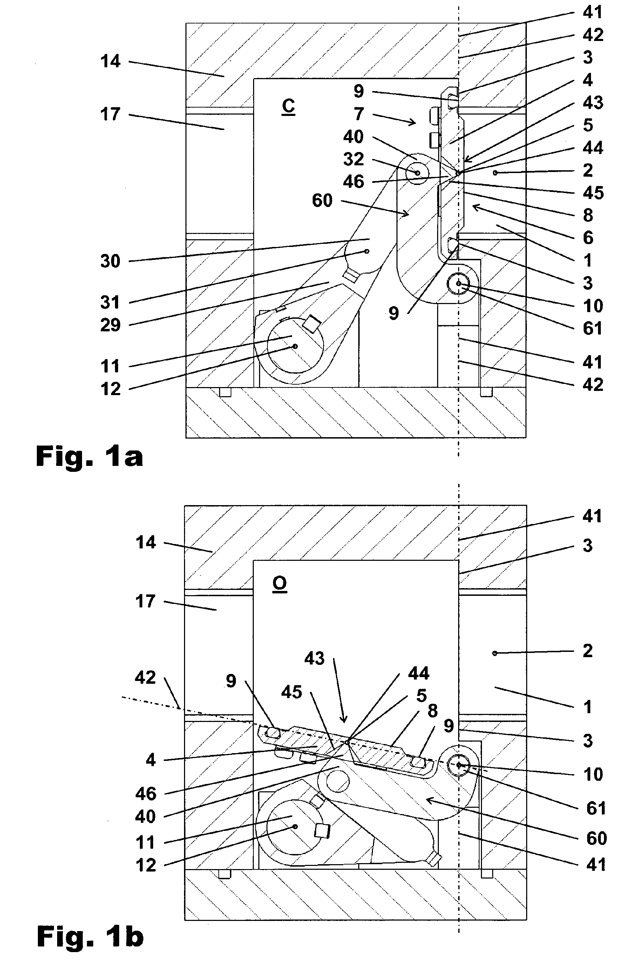

Die Figuren 1a bis 1e zeigen eine gemeinsame, exemplarische Ausführungsform eines erfindungsgemässen Klappen-Transferventils in unterschiedlichen Zuständen, aus unterschiedlichen Ansichten und in unterschiedlichen Detaillierungsgraden. Daher werden diese Figuren gemeinsam beschrieben, wobei zum Teil auf bereits in vorangegangenen Figuren erläuterte Bezugszeichen und Merkmale nicht erneut eingegangen wird.

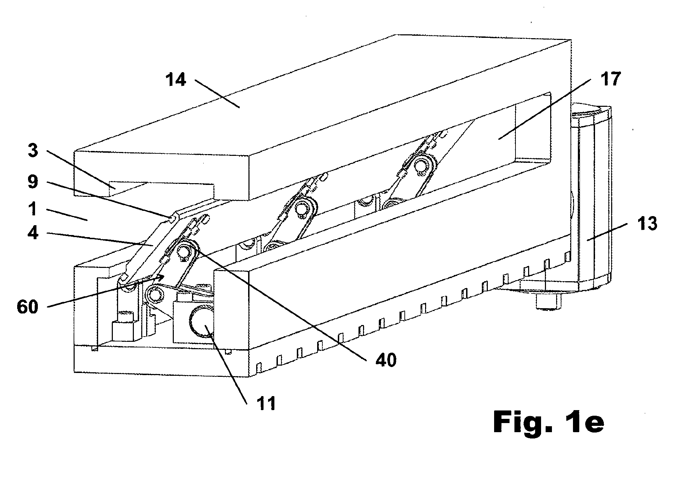

Das Klappen-Transferventil für den Transfer von Halbleiterelementen oder Substraten in eine gasdicht isolierbare Halbleiter- oder Substratbearbeitungs-Prozesskammer hat ein gasdichtes Ventilgehäuse 14, das die Grundform eines Quaders aufweist, wie in Figur 1e erkennbar. Zwei gegenüberliegende seitliche langgestreckte Seiten bilden eine erste Öffnungsseite und eine zweite Öffnungsseite des Ventilgehäuses 14. Auf der ersten Öffnungsseite des Ventilgehäuses 14 ist eine langgestreckte, schlitzartige erste Öffnung 1 ausgeformt, welche einen rechteckigen Querschnitt aufweist, wie in den Figuren 1a, 1b und 1e ersichtlich. Der ersten Öffnung 1 liegt einer zweiten Öffnung 17 gegenüber, die sich auf der zweiten Öffnungsseite Ventilgehäuses 14 befindet. Die beiden Öffnungen 1 und 17 haben im Wesentlichen den gleichen langgestreckten, schlitzartigen Querschnitt und fluchten in ihrer Projektion. In anderen Worten weisen die beiden Öffnungen 1 und 17 eine gemeinsame Öffnungsachse auf. Die erste Öffnung 1 erstreckt sich entlang einer ersten Längsachse 2 und ist von einer ersten Dichtfläche 3 rahmenförmig umschlossen, wie in Figur 1a, 1b und 1e gezeigt. Die erste Dichtfläche 3 verläuft in einer ersten Dichtebene 41 und bildet einen ebenen, in das Ventilinnere weisenden Ventilsitz.

Im Ventilgehäuse ist ein langgestreckter Ventilverschlussbalken 4 angeordnet, der sich entlang einer zur ersten Längsachse 2 im Wesentlichen parallelen zweiten Längsachse 5 erstreckt, wie u. a. in den Figuren 1a und 1b gezeigt. Der Ventilverschlussbalken 4 weist einen Querschnitt auf, der im Wesentlichen den Querschnitten der Öffnungen 1 und 17 entspricht, jedoch etwas grösser ist, so dass er die erste Öffnung 1 überdecken kann.

Im gezeigten Ausführungsbeispiel beträgt die Breite der beiden Öffnungen 1 und 17 sowie des Ventilverschlussbalkens 4 über das Sechsfache der jeweiligen Höhe. Die Querschnitte erstrecken sich somit wesentlich mehr in die Breite, also in die Länge, als in die Höhe, weshalb die Querschnitte als langgestreckt bezeichnet werden.

Auf einer Vorderseite 6 des Ventilverschlussbalkens 4 befindet sich eine Verschlussfläche 8 zum Verschliessen der ersten Öffnung 1. Ausserdem ist im Randbereich der Verschlussfläche 8 eine zweite Dichtfläche 9 in Form eines O-Rings angeordnet. Der O-Ring 9 korrespondiert mit der ersten Dichtfläche 3, er ist also mit der ersten Dichtfläche 3 in gasdichten Kontakt bringbar, wie in Figur 1a gezeigt. Die wirksame Fläche des O-Rings 9, also die zweite Dichtfläche 9, liegt in einer zweiten Dichtebene 42, wie in den Figuren 1a und 1b gezeigt. Da sich in Figur 1a das Klappen-Transferventil in der Geschlossenstellung C befindet, fallen dort die erste Dichtebene 41 und die zweite Dichtebene 42 zusammen.

Auf der Rückseite 7 des Ventilverschlussbalkens 4 sind mehrere gleichartige Abstützungen 40 entlang der zweiten Längsachse 5 angeordnet, wie insbesondere in Figur 1e erkennbar. Im Folgenden wird allerdings zur besseren Veranschaulichung von einer einzigen Abstützung 40 ausgegangen. Die Abstützung 40 bildet die Schnittstelle zwischen dem Ventilverschlussbalken 4 und einer Schwenklagerung 60. Der Ventilverschlussbalken 4 ist über eine schwenkbare Verbindung 43, die im Folgenden genauer erläutert wird, an der Abstützung 40 um eine zur zweiten Längsachse 5 parallele Kippachse 44 schwenkbar angeordnet.

Neben der ersten Öffnung 1 ist eine sich parallel zur ersten Längsachse 2 der ersten Öffnung 1 und entlang einer Schwenkachse 10 erstreckende Schwenkwelle 61 angeordnet. An dieser Schwenkwelle 61 ist die Abstützung 40 über einen Arm zum Schwenken um die Schwenkachse 10 befestigt. Der Ventilverschlussbalken 4 ist also um die Schwenkachse 10 schwenkbar gelagert. Die Schwenkachse 10 verläuft seitlich zur ersten Öffnung 1, nämlich erfindungsgemäss in der ersten Dichtebene 41, wie in den Figuren 1a und 1b gezeigt.

Die schwenkbare Lagerung des Ventilverschlussbalkens 4 um die zur zweiten Längsachse 5 parallele Schwenkachse 10 bildet funktional die Schwenklagerung 60, mittels welcher der Ventilverschlussbalken 4 um die Schwenkachse 10 zwischen einer Geschlossenstellung C, Figur 1a, und einer Offenstellung O, Figur 1b, mit einem Schwenkwinkel von etwa 80° schwenkbar ist. In der Geschlossenstellung C, Figur 1a, überdeckt der Ventilverschlussbalken 4 mit der Verschlussfläche 8 die erste Öffnung 1 und verschliesst sie.

In dieser Geschlossenstellung C stehen die erste Dichtfläche 3 und die zweite Dichtfläche 9 in gasdichtem Kontakt miteinander, wobei die erste Dichtebene 41 und die zweite Dichtebene 42 aufeinander liegen, wie in Figur 1a gezeigt. In der Offenstellung O ist der Ventilverschlussbalken 4 von der ersten Öffnung 1 weggeschwenkt und gibt die erste Öffnung 1 frei.

Am Ventilgehäuse 14 ist eine Welle 11 radial und drehbar gelagert, die um eine zur zweiten Längsachse 5 des Ventilverschlussbalkens 4 im Wesentlichen parallele Wellenachse 12 drehbar ist, wie in den Figuren 1a, 1b und 1e gezeigt. Die Wellenachse 12 verläuft in Richtung senkrecht zur ersten Dichtebene 41 der ersten Dichtfläche 3 von der Schwenkachse 10 beabstandet. Die Schwenkwelle 61 mit ihrer Schwenkachse 10 verläuft durch die zur ersten Öffnungsseite weisenden Hälfte des Ventilgehäuses 14, wohingegen die Welle 11 mit ihrer Wellenachse 12 durch die zur zweiten Öffnungsseite weisenden Hälfte des Ventilgehäuses 14 läuft, wie aus Figur 1a und 1b ersichtlich.

An der Welle 11 ist jeweils ein erster Arm 29 drehfest angeordnet. Die insgesamt drei ersten Arme 29, wie in Figur 1e gezeigt, verlaufen parallel zueinander und senkrecht zur Wellenachse 12. Durch Drehen der Welle 11 sind die ersten Arme 29 um die Wellenachse 12 schwenkbar.

Den ersten Armen 29 ist jeweils ein zweiter Arm 30 zugeordnet. Der zweite Arm 30 ist auf der Rückseite 7 des Ventilverschlussbalkens 4 um eine zweite Armachse 32, die parallel zur Schwenkachse 10 verläuft, an der Abstützung 40 schwenkbar gelagert. Der jeweilige erste Arm 29 und zweite Arm 30 sind an ihren freien Enden um eine zur zweiten Armachse 32 im Wesentlichen parallele erste Armachse 31 gelenkig miteinander verbunden. Die Welle 11, die ersten Arme 29 und die zweiten Arme 30 bilden somit einen Hebelantrieb. Somit steht der jeweilige erste Arm 29 über den zweiten Arm 30 mit der Abstützung 40 auf der Rückseite 7 des Ventilverschlussbalkens 4 derart in Eingriff, dass durch Drehen der Welle 11 und somit durch Schwenken der ersten Arme 29 um die Wellenachse 12 eine Kraft auf die Rückseite 7 des Ventilverschlussbalkens 4 zum Schwenken des Ventilverschlussbalkens 4 um die Schwenkachse 10 zwischen der Offenstellung O und der Geschlossenstellung C aufbringbar ist.

Die Längen der ersten Arme 29 und der zweiten Arme 30 und die Abstände der Wellenachse 12, der ersten Armachse 31 und der zweiten Armachse 32 sind derart, dass die Wellenachse 12, die erste Armachse 31 und die zweite Armachse 32 in der Geschlossenstellung C im Wesentlichen in einer gemeinsamen Ebene liegen, wie in Figur 1a gezeigt, und sich die ersten Arme 29 und die zweiten Arme 30 im Wesentlichen in Totpunktausrichtung befinden.

Die um die Wellenachse 12 drehbare Welle 11 steht über die Arme 29 und 30 also in derartiger Wirkverbindung zu der Abstützung 40 und dem Ventilverschlussbalken 4, dass ein Drehen der Welle 11 um die Wellenachse 12 ein Schwenken des Ventilverschlussbalkens 4 um die Schwenkachse 10 bewirkt.

Zum Drehen der Welle 11 um die Wellenachse 12 und zum Verstellen des Ventilverschlussbalkens 4 zwischen der Offenstellung O und der Geschlossenstellung C ist ein Antrieb 13 in Form eines Elektromotors seitlich am Ventilgehäuse 14 angeordnet, wie in Figur 1e gezeigt.

Erfindungsgemäss besteht zwischen der Abstützung 40, die auf der Rückseite 7 des Ventilverschlussbalkens 4 angeordnet ist, und dem Ventilverschlussbalken 4 eine schwenkbare Verbindung 43 um die zur zweiten Längsachse 5 parallele Kippachse 44, wobei die Kippachse 44 in der zweiten Dichtebene 42 liegt, wie in den Figuren 1a und 1b gezeigt.

Die im Randbereich der Verschlussfläche 8 liegende zweite Dichtfläche 9 ist in Richtung zur Rückseite 7 zurückversetzt, wie in den Figuren 1a und 1b gezeigt. Somit ragt die Verschlussfläche 8 in einem mittleren Bereich, der von dem O-Ring 9 umgeben ist, über die zweite Dichtebene 42 in Richtung der Vorderseite 6 des Ventilverschlussbalkens 4 hinaus, wie in den Figuren 1a und 1b gezeigt. In anderen Worten ragt die Verschlussfläche 8 in der Geschlossenstellung C über die erste Dichtebene 41 hinaus in die erste Öffnung 1 hinein, wie in Figur 1a gezeigt.

Auf der Rückseite 7 des Ventilverschlussbalkens 4 ist im dem mittleren Bereich des Ventilverschlussbalken 4 pro Abstützung 40 jeweils eine Ausnehmung 45 ausgeformt, die sich bis in die zweite Dichtebene 42 in Richtung zur Vorderseite 6 erstreckt. Die längs entlang der Kippachse 44 verlaufende, mittig im Ventilverschlussbalken 4 ausgeformte Ausnehmung 45 wird jeweils von einer als eine sich zumindest teilweise entlang der Kippachse 44 erstreckenden V-förmigen Nut gebildet, wobei der Boden 47 der Nut 45 eine Linienform entlang der Kippachse 44 hat und somit in der zweiten Dichtebene 42 verläuft.

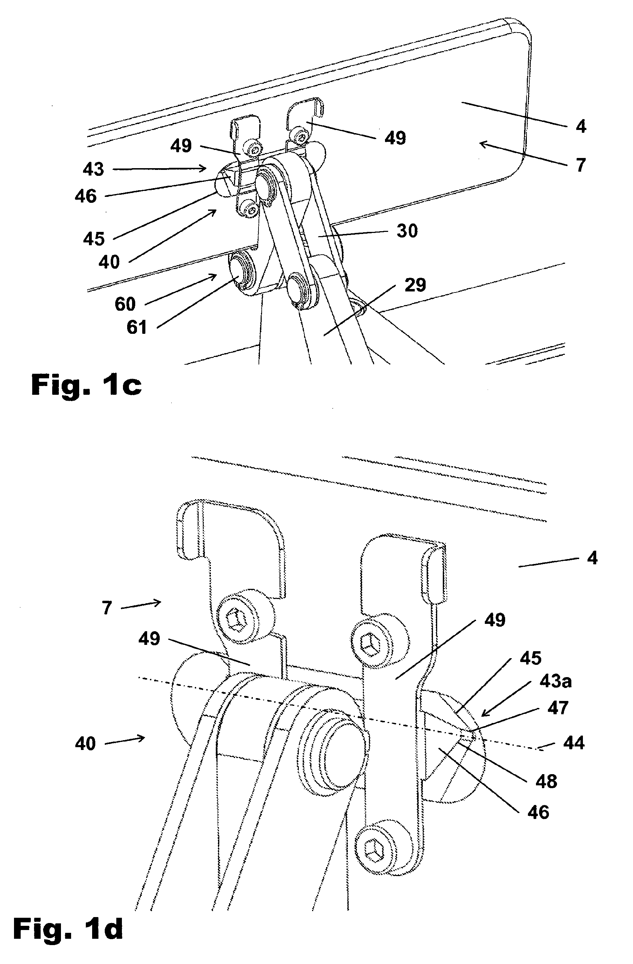

In anderen Worten hat diese Ausnehmung 45 in Bezug zu einer gedachten Ebene, die von der Kippachse 44 und der zweiten Längsachse 5 senkrecht durchstossen wird, also der Querschnittsebene der Figuren 1a und 1b, einen nach innen zusammenlaufenden, V-förmigen Querschnitt. Der Boden 47 der Ausnehmung 45, Figur 1d, wird von dem stumpf zusammenlaufenden V-Winkel gebildet, wie in den Figuren 1a, 1b und 1d gezeigt, und von der Kippachse 44 durchlaufen.

Jede der Abstützungen 45 besitzt jeweils einen Vorsprung 46. Der Vorsprung 46 ist als ein sich entlang der Kippachse 44 erstreckender Keil mit einem V-förmigen Querschnitt ausgebildet und besitzt im Querschnitt eine Spitze 48, die von dem spitz zusammenlaufenden V-Winkel gebildet wird. In anderen Worten hat der Vorsprung 46 eine Keilform mit einem spitzen Grat 48, der eine Linienform hat. In Bezug zu einer gedachten Ebene, die von der Kippachse 44 und der zweiten Längsachse 5 senkrecht durchstossen wird, also der Querschnittsansicht gemäss den Figuren 1a und 1b, hat der Vorsprung 46 einen spitz zusammenlaufenden Querschnitt mit einer Spitze 48.

Der V-Winkel der Ausnehmung 45 ist grösser als der V-Winkel des Vorsprungs 46, so dass der Vorsprung 46 vollständig in die Ausnehmung 45 hinein ragen kann, wobei der linienförmige Grat 48 bzw. die Spitze 48 des Vorsprungs 46 auf dem linienförmigen Boden 47 der Ausnehmung 45 aufliegt. Zwischen der Spitze 48 bzw. dem Grat 48 und dem Boden 47 besteht somit ein auf der Kippachse 44 liegender, derartiger linienförmiger Kontakt zwischen dem Vorsprung 46 und der Ausnehmung 45, dass der Ventilverschlussbalken 4 relativ zur Abstützung 40 um die Kippachse 41 schwenkbar ist. Mittels dieses Kontakts wird eine schwenkbare Verbindung 43 in Form eines Kippgelenk 43a gebildet.

Zwischen dem Ventilverschlussbalken 4 und der Abstützung 40 ist eine Federanordnung 49 in Form jeweils zweier auf der Rückseite 7 montierter Blattfedern angeordnet. Die Blattfedern 49 sind quer zur Kippachse 44 hinter dem in die Ausnehmung 45 hineinragenden Vorsprung 46 montiert, so dass der Ventilverschlussbalken 4 auf der Abstützung 40 gehalten und der Vorsprung 46 in die Ausnehmung 45 gedrückt wird, wie in den Figuren 1c und 1d gezeigt. Die Blattfedern 49 sind mittels Schrauben quer über die nutförmige Ausnehmung 45 und über den in die Ausnehmung 45 ragende Vorsprung 46 befestigt, so dass eine um die Kippachse 44 federnd schwenkbare Verbindung zwischen der Abstützung 40 und dem Verschlussbalken 4 besteht.

Durch die erfindungsgemässe Anordnung der Schwenkachse 10 in der ersten Dichtebene 41 und der Kippachse 44 in der zweiten Dichtebene 42, die insbesondere mittels der erfindungsgemässen Lageranordnung ermöglicht wird, lässt sich eine Querverschiebung der Dichtflächen 3 und 9 bei Anpressen des Ventilverschlussbalkens 4 beim Übergang in die Geschlossenstellung C, Figur 1a, vermeiden, so dass der O-Ring 9 einem nur sehr geringen Verschleiss unterworfen und dessen Lebensdauer erheblich gesteigert wird. Aufgrund des linienförmigen Kontakts zwischen dem Vorsprung 46 und der Ausnehmung 45 wird die reibungsbedingte Partikelgenerierung gering gehalten, wodurch die geforderte Partikelfreiheit gewährleistet bleibt.

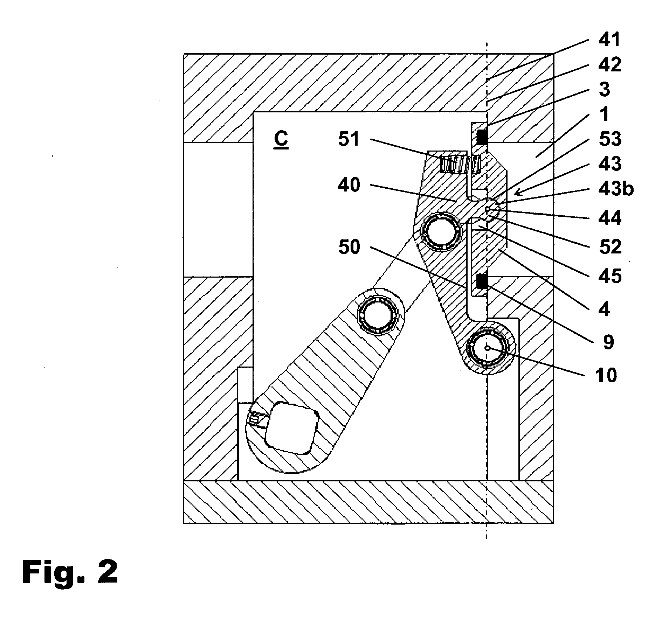

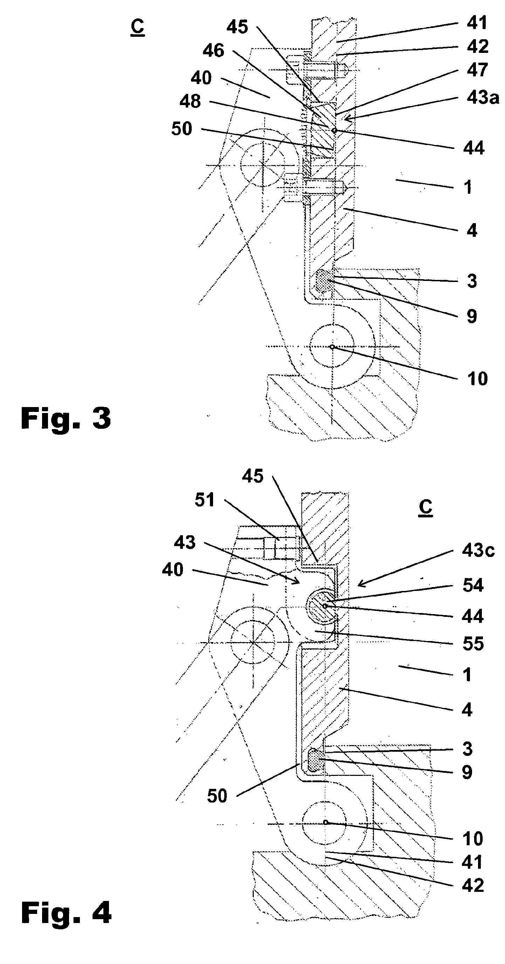

Anstelle des in den Figuren 1a bis 1e beschriebenen Kippgelenks 43a ist es erfindungsgemäss möglich, auch eine andere Ausführungsform eines Kippgelenks 43a, beispielsweise gemäss Figur 3, oder ein anderes Gelenk mit einer in der zweiten Dichtebene 42 liegenden Kippachse 44, beispielsweise ein Kugelgelenk 43b, Figur 2 oder ein Schwenkgelenk 43c, Figur 4, zu verwenden. Mögliche alternative Ausführungsformen werden im Folgenden nicht abschliessend dargestellt, wobei lediglich auf die Unterschiede zu der bereits erläuterten Ausführungsform eingegangen wird.

In Figur 2 ist eine schwenkbare Verbindung 43 zwischen der Abstützung 40 und dem Ventilverschlussbalken 4 dargestellt, die von mindestens einem Kugelgelenk 43b gebildet wird. Das Kugelgelenk 43b wird von einer in der Abstützung 40 ausgeformten Kugel 52 und einer entsprechenden Kugelaufnahme 53, die in der Ausnehmung 45 ausgeformt ist, gebildet. Das Zentrum der Kugel 52 und einer entsprechenden Kugelaufnahme 53 in Bezug zu der Ebene, die von der Kippachse 44 und der zweiten Längsachse 5 senkrecht durchstossen wird, also der Querschnittsebene gemäss Figur 2, befindet sich auf der Kippachse 44 und somit in der zweiten Dichtebene 42.

Ausserdem weist die alternative Ausführungsform aus Figur 2 einen den Schwenkwinkel begrenzenden Schwenkanschlag 50 zwischen dem Ventilverschlussbalken 4 und der Abstützung 40 auf. Eine in Richtung senkrecht zur zweiten Dichtebene 42 wirkende Feder 51 ist zwischen dem Ventilverschlussbalken 4 und der Abstützung 40 angeordnet. Die Feder 51 drückt in der Offenstellung O den Ventilverschlussbalken 4 an den Schwenkanschlag 50, so dass der Ventilverschlussbalken 4 in der Offenstellung O gegenüber der Abstützung 40 derart verkippt ist, dass beim Schwenken der Abstützung 40 und des Ventilverschlussbalkens 4 mittels der Schwenklagerung 60 von der Offenstellung O in die Geschlossenstellung C beim Herstellen des Kontakts zwischen ersten Dichtfläche 3 und der zweiten Dichtfläche 9 diese Dichtflächen 3 und 9 eben aufeinander zum Liegen kommen. Diese Anordnung ist auch bei dem ersten Ausführungsbeispiel aus den Figuren 1a bis 1e umsetzbar.

In Figur 3 ist eine zweite alternative Ausführungsform gezeigt, bei welcher der Boden 47 der Ausnehmung 45 flach ausgebildet ist und sich auf der zweiten Dichtebene 42 erstreckt. Der Vorsprung 46 der Abstützung 40 weist eine sich entlang der Kippachse 44 erstreckende Spitze 48 in Form einer Kante auf. In der Geschlossenstellung C liegt die Kante 48 und die obere Hälfte des Vorsprungs 46 auf dem Boden 47 auf. Sobald die Geschlossenstellung C verlassen wird, kippt der Ventilverschlussbalken 4 um die Kippachse 44 und um die Kante 48 auf die untere Hälfte des Vorsprungs 46, die den Schwenkanschlag 50 bildet, so dass der Ventilverschlussbalken 4 in der Offenstellung O gegenüber der Abstützung 40 wie oben beschrieben verkippt ist. Durch diese Anordnung wird eine Kippgelenk 43a mit einem begrenzten Schwenkwinkel gebildet. Ausserdem weist der Ventilverschlussbalken 4 entsprechend dem Ausführungsbeispiel aus den Figuren 1a bis 1e eine in Figur 3 nicht dargestellte Federanordnung 49 zum Drücken des Vorsprungs 46 in die Ausnehmung 45 auf.

In Figur 4 ist eine dritte alternative Ausführungsform mit einem Schwenkgelenk 43c gezeigt. In der Ausnehmung 45 befindet sich ein sich entlang der Kippachse 44 erstreckender Bolzenabschnitt 54, dessen Mittelachse auf der Kippachse 44 liegt. Der Bolzenabschnitt 54 ist in einer mit der Abstützung 40 gekoppelten Bolzenaufnahme 55 aufgenommen, so dass der Bolzenabschnitt 54 und die Bolzenaufnahme 55 und somit der Ventilverschlussbalken 4 und die Abstützung 40 relativ zueinander um die auf der zweiten Dichtebene 42 liegende Kippachse 44 schwenkbar sind, wodurch das Schwenkgelenk 43c gebildet wird. Wie auch die erste alternative Ausführungsbeispiel aus Figur 2 besitzt diese dritte alternative Ausführungsform einen Schwenkanschlag 50 und eine Feder 51, so dass der Ventilverschlussbalken 4 im nicht geschlossenen Zustand des Klappen-Transferventils eine definierte Stellung einnimmt.

Die in den Figuren 1a bis 1e, 2, 3 und 4 veranschaulichten und erläuterten, konkreten vier Ausführungsbeispiele dienen lediglich zur exemplarischen Veranschaulichung der Erfindung anhand schematischer Darstellungen. Selbstverständlich beschränkt sich die Erfindung nicht auf diese Ausführungsbeispiel und deren Merkmalskombinationen.

## Patentansprüche

1. Klappen-Transferventil für den Transfer von Halbleiterelementen oder Substraten in eine gasdicht isolierbare Halbleiter- oder Substratbearbeitungs-Prozesskammer, mit
• einer langgestreckten, insbesondere schlitzartigen ersten Öffnung (1), die sich entlang einer ersten Längsachse (2) erstreckt und die von einer in einer geometrischen ersten Dichtebene (41) liegenden ersten Dichtfläche (3) der ersten Öffnung (1) rahmenförmig umschlossen ist,
• einem langgestreckten Ventilverschlussbalken (4), der
- sich entlang einer zur ersten Längsachse (2) parallelen zweiten Längsachse (5) erstreckt,
- auf einer Vorderseite (6) eine Verschlussfläche (8) zum Verschliessen der ersten Öffnung (1) aufweist und
- eine zweite Dichtfläche (9) aufweist, die
· mit der ersten Dichtfläche (3) korrespondiert,
· mit der ersten Dichtfläche (3) in gasdichten Kontakt bringbar ist,
· im Randbereich der Verschlussfläche (8) liegt und
· in einer geometrischen zweiten Dichtebene (42) liegt,
• mindestens einer Abstützung (40) auf einer der Vorderseite (6) gegenüberliegenden Rückseite (7) des Ventilverschlussbalkens (4), wobei der Ventilverschlussbalken (4) über eine schwenkbare Verbindung (43) an der Abstützung (40) um eine zur zweiten Längsachse (5) parallele geometrische Kippachse (44) um einem begrenzten Schwenkwinkel schwenkbar angeordnet ist, und
• einer Schwenklagerung (60), wobei die Schwenklagerung (60), die erste Öffnung (1) und der Verschlussbalken (4) derart ausgebildet sind, dass mittels der Schwenklagerung (60)die Abstützung (40) mit dem Ventilverschlussbalken (4) um eine zur zweiten Längsachse (5) parallele geometrische Schwenkachse (10) zwischen
- einer Geschlossenstellung (C), in welcher
der Ventilverschlussbalken (4) mit der Verschlussfläche (8) die erste Öffnung (1) überdeckt und verschliesst,
· die erste Dichtfläche (3) der ersten Öffnung (1) und die zweite Dichtfläche (9) des Ventilverschlussbalkens (4) in gasdichtem Kontakt stehen, parallel sind und in einer gemeinsamen Ebene aufeinander liegen und
· die erste Dichtebene (41) der ersten Dichtfläche (3) der ersten Öffnung (1) und die zweite Dichtebene (42) der zweiten Dichtfläche (9) des Ventilverschlussbalkens (4) aufeinander liegen
und
- einer Offenstellung (O), in welcher der Ventilverschlussbalken (4) von der ersten Öffnung (1) weggeschwenkt ist und die erste Öffnung (1) zumindest teilweise freigibt,
schwenkbar ist,
**dadurch gekennzeichnet, dass**
• die Schwenkachse (10) im Wesentlichen in der ersten Dichtebene (41) der ersten Dichtfläche (3) der ersten Öffnung (1) liegt,
• die Kippachse (44) im Wesentlichen in der zweiten Dichtebene (42) der zweiten Dichtfläche (9) des Ventilverschlussbalkens (4) liegt,
• die im Randbereich der Verschlussfläche (8) liegende zweite Dichtfläche (9) in Richtung zur Rückseite (7) derart zurückversetzt ist, dass die Verschlussfläche (8) - zumindest in einem mittleren Bereich des Ventilverschlussbalken (4) - über die zweite Dichtebene (42) in Richtung der Vorderseite (6) des Ventilverschlussbalkens (4) hinausragt,
• auf der Rückseite (7) des Verschlussbalkens (4) - zumindest in dem mittleren Bereich des Ventilverschlussbalken (4) - mindestens eine Ausnehmung (45) ausgeformt ist, die sich mindestens bis in die zweite Dichtebene (42) in Richtung zur Vorderseite (6) erstreckt, wobei sich die Kippachse (44) im Bereich der Ausnehmung (45) erstreckt, und
• die schwenkbare Verbindung (43) in der Ausnehmung (45) angeordnet ist.

2. Klappen-Transferventil nach Anspruch 1,
**dadurch gekennzeichnet, dass**
die schwenkbare Verbindung (43) zwischen der Abstützung (40) und dem Ventilverschlussbalken von mindestens einem
• Kippgelenk (43a),
• Kugelgelenk (43b) oder
• Schwenkgelenk (43c)
gebildet wird.

3. Klappen-Transferventil nach Anspruch 1,
**dadurch gekennzeichnet, dass**
die schwenkbare Verbindung (43) von
• der mindestens einen Ausnehmung (45) und
• mindestens einem Vorsprung (46) der Abstützung (45) gebildet wird, wobei
• der Vorsprung (46) in die Ausnehmung (45) hineinragt und ein derartiger Kontakt zwischen dem Vorsprung (46) und der Ausnehmung (45) besteht, dass der Ventilverschlussbalken (4) relativ zur Abstützung (40) um die Kippachse (41) schwenkbar ist.

4. Klappen-Transferventil nach Anspruch 3,
**dadurch gekennzeichnet, dass**
• die schwenkbare Verbindung (43) als Kippgelenk (43a) ausgebildet ist,
• die Ausnehmung (45) einen Boden (47) aufweist und
• der Vorsprung (47) in Bezug zu der Ebene, die von der Kippachse (44) und der zweiten Längsachse (5) senkrecht durchstossen wird, einen spitz zusammenlaufenden Querschnitt mit einer Spitze (48) aufweist,
wobei zwischen der Spitze (48) und dem Boden (47) ein auf der Kippachse (44) liegender punktförmiger oder linienförmiger Kontakt besteht, der das Kippgelenk (43a) bildet.

5. Klappen-Transferventil nach Anspruch 4,
**dadurch gekennzeichnet, dass**
der Vorsprung (47) einen V-förmigen Querschnitt aufweist und die Spitze (48) von dem spitz zusammenlaufenden V-Winkel gebildet wird.

6. Klappen-Transferventil nach Anspruch 4 oder 5,
**dadurch gekennzeichnet, dass**
die der Ausnehmung (45) einen in Bezug zu der Ebene, die von der Kippachse (44) und der zweiten Längsachse (5) senkrecht durchstossen wird, einen nach innen zusammenlaufenden Querschnitt aufweist.

7. Klappen-Transferventil nach Anspruch 6,
**dadurch gekennzeichnet, dass**
die Ausnehmung (45) einen V-förmigen Querschnitt aufweist und der Boden (47) von dem stumpf zusammenlaufenden V-Winkel gebildet wird.

8. Klappen-Transferventil nach einem der Ansprüche 3 bis 7, **dadurch gekennzeichnet, dass**
• die Ausnehmung (45) als eine sich zumindest teilweise entlang der Kippachse (44) erstreckende Nut ausgebildet ist, wobei der Boden (47) der Nut (45) in der zweiten Dichtebene (42) verläuft, und
• der Vorsprung (46) als ein sich entlang der Kippachse (44) erstreckender Keil ausgebildet ist.

9. Klappen-Transferventil nach einem der Ansprüche 3 bis 8, **gekennzeichnet durch**
eine Federanordnung (49) zwischen dem Ventilverschlussbalken (4) und der Abstützung (40), wobei die Federanordnung (49) derart angeordnet ist, dass
• der Ventilverschlussbalken (4) auf der Abstützung (40) gehalten und
• der Vorsprung (46) in die Ausnehmung (45) gedrückt wird.

10. Klappen-Transferventil nach Anspruch 9,
**dadurch gekennzeichnet, dass**
die Federanordnung (49) als mindestens eine auf der Rückseite (7) des Ventilverschlussbalkens (4) angeordnete Blattfeder, die quer zur Kippachse (44) hinter dem in die Ausnehmung (45) hineinragenden Vorsprung (46) angeordnet ist und den Vorsprung (46) in die Ausnehmung (45) drückt, ausgebildet ist.

11. Klappen-Transferventil nach einem der Ansprüche 1 bis 10, **gekennzeichnet durch**
• einen den Schwenkwinkel begrenzenden Schwenkanschlag (50) zwischen dem Ventilverschlussbalken (4) und der Abstützung (40) und
• mindestens eine Feder (51) zwischen dem Ventilverschlussbalken (4) und der Abstützung (40),
wobei
• die mindestens eine Feder (51) in der Offenstellung (O) den Ventilverschlussbalken (4) an den Schwenkanschlag (50) drückt und
• der Ventilverschlussbalken (4) in der Offenstellung (O) gegenüber der Abstützung (40) derart verkippt ist, dass beim Schwenken der Abstützung (40) und des Ventilverschlussbalkens (4) mittels der Schwenklagerung (60) von der Offenstellung (O) in die Geschlossenstellung (C) beim Herstellen des Kontakts zwischen ersten Dichtfläche (3) und der zweiten Dichtfläche (9) diese Dichtflächen (3, 9) eben aufeinander zum Liegen kommen.

12. Klappen-Transferventil nach einem der Ansprüche 1 bis 11,
**dadurch gekennzeichnet, dass**
neben der ersten Öffnung (1) eine sich parallel zur ersten Längsachse (2) der ersten Öffnung (1) und entlang der Schwenkachse (10) erstreckende Schwenkwelle (61) angeordnet ist, an welcher die Abstützung (40) zum Schwenken um die Schwenkachse (10) befestigt ist.

13. Klappen-Transferventil nach einem der Ansprüche 1 bis 12, **gekennzeichnet durch**
• eine Welle (11), die um eine zur zweiten Längsachse (5) im Wesentlichen parallele Wellenachse (12), die von der Schwenkachse (10) beabstandet ist, drehbar ist,
• mindestens einem Antrieb (13), der mit der Welle (11) zum Drehen der Welle (11) um die Wellenachse (12) und Verstellen des Ventilverschlussbalkens (4) zwischen der Offenstellung (O) und der Geschlossenstellung (C) gekoppelt ist, und
• mindestens einen an der Welle (11) drehfest angeordneten ersten Arm (29), der an seinem freien Ende direkt oder indirekt über die Abstützung (40) mit der Rückseite (7) des Ventilverschlussbalkens (4) derart in Eingriff steht, dass **durch** Drehen der Welle (11) und somit **durch** Schwenken des ersten Arms (29) um die Wellenachse (12) eine Kraft auf die Rückseite (7) des Ventilverschlussbalkens (4) zum Schwenken des Ventilverschlussbalkens (4) um die Schwenkachse (10) zwischen der Offenstellung (O) und der Geschlossenstellung (C) aufbringbar ist.

## Claims

1. Flap transfer valve for the transfer of semiconductor elements or substrates into a semiconductor or substrate processing process chamber which can be isolated in a gas-tight manner, having
• an elongated, in particular slot-like, first opening (1), which extends along a first longitudinal axis (2) and is surrounded in the form of a frame by a first sealing surface (3) of the first opening (1) which lies on a geometric first sealing plane (41),
• an elongated valve closure beam (4), which
- extends along a second longitudinal axis (5), which is parallel to the first longitudinal axis (2),
- has a closure surface (8) on a front face (6) for closing the first opening (1), and
- has a second sealing surface (9), which
° corresponds to the first sealing surface (3),
° can be brought into gas-tight contact with the first sealing surface (3), and is located in the edge area of the closure surface (8) and
° is located on a geometric second sealing plane (42),
• at least one support (40) on a rear face (7), which is opposite the front face (6), of the valve closure beam (4), wherein the valve closure beam (4) is arranged such that it can pivot through a limited pivoting angle about a geometric tilting axis (44), which is parallel to the second longitudinal axis (5), via a pivotable connection (43) on the support (40), and
• a pivoting bearing (60), wherein the pivoting bearing (60), the first opening (1) and the closure beam (4) are designed in such a way that by means of the pivoting bearing (60) the support (40), together with the valve closure beam (4), can pivot about a geometric pivoting axis (10), which is parallel to the second longitudinal axis (5), between
- a closed position (C), in which
° the closure surface (8) of the valve closure beam (4) covers and closes the first opening (1),
° the first sealing surface (3) of the first opening (1) and the second sealing surface (9) of the valve closure beam (4) are in gas-tight contact, are parallel and lie on one another on a common plane, and
° the first sealing plane (41) of the first sealing surface (3) of the first opening (1) and the second sealing plane (42) of the second sealing surface (9) of the valve closure beam (4) lie on one another, and
- an open position (O) in which the valve closure beam (4) is pivoted away from the first opening (1) and at least partially releases the first opening (1),
**characterized in that**
• the pivoting axis (10) lies essentially on the first sealing plane (41) of the first sealing surface (3) of the first opening (1),
• the tilting axis (44) lies essentially on the second sealing plane (42) of the second sealing surface (9) of the valve closure beam (4),
• the second sealing surface (9), which is located in the edge area of the closure surface (8), is set back in the direction of the rear face (7) such that the closure surface (8) - at least in a central area of the valve closure beam (4) - projects beyond the second sealing plane (42) in the direction of the front face (6) of the valve closure beam (4),
• at least one recess (45) is formed on the rear face (7) of the closure beam (4) - at least in the central area of the valve closure beam (4) - and extends at least onto the second sealing plane (42) in the direction of the front face (6), wherein the tilting axis (44) extends in the area of the recess (45), and
• the pivotable connection (43) is arranged in the recess (45).

2. Flap transfer valve according to Claim 1,
**characterized in that**
the pivotable connection (43) between the support (40) and the valve closure beam is formed by at least one
• tilting joint (43a),
• ball joint (43b) or
• pivoting joint (43c).

3. Flap transfer valve according to Claim 1,
**characterized in that**
the pivotable connection (43) is formed by
• the at least one recess (45) and
• at least one projection (46) on the support (45), wherein
• the projection (46) projects into the recess (45), and a contact exists between the projection (46) and the recess (45) such that the valve closure beam (4) can pivot about the tilting axis (41) relative to the support (40).

4. Flap transfer valve according to Claim 3,
**characterized in that**
• the pivotable connection (43) is in the form of a tilting joint (43a),
• the recess (45) has a base (47) and
• the projection (47) has a cross section which converges to a point and has a tip (48), with respect to the plane through which the tilting axis (44) and the second longitudinal axis (5) pass at right angles,
wherein there is a point or line contact on the tilting axis (44) between the tip (48) and the base (47), and this forms the tilting joint (43a).

5. Flap transfer valve according to Claim 4,
**characterized in that**
the projection (47) has a V-shaped cross section, and the tip (48) is formed by the V-angle which converges at a point.

6. Flap transfer valve according to any one of Claims 4 or 5,
**characterized in that**
the recess (45) has a cross section which converges inwards with respect to the plane through which the tilting axis (44) and the second longitudinal axis (5) pass at right angles.

7. Flap transfer valve according to Claim 6,
**characterized in that**
the recess (45) has a V-shaped cross section, and the base (47) is formed by the V-angle, which converges bluntly.

8. Flap transfer valve according to any one of Claims 3 to 7,
**characterized in that**
• the recess (45) is in the form of a groove which extends at least partially along the tilting axis (44), wherein the base (47) of the groove (45) runs on the second sealing plane (42), and
• the projection (46) is in the form of a wedge which extends along the tilting axis (44).

9. Flap transfer valve according to any one of Claims 3 to 8,
**characterized by**
a spring arrangement (49) between the valve closure beam (4) and the support (40), wherein the spring arrangement (49) is arranged such that
• the valve closure beam (4) is held on the support (40), and
• the projection (46) is pushed into the recess (45).

10. Flap transfer valve according to Claim 9,
**characterized in that**
the spring arrangement (49) is in the form of at least one leaf spring, which is arranged on the rear face (7) of the valve closure beam (4), presses the projection (46) into the recess (45), and is arranged transversely with respect to the tilting axis (44), behind the projection (46) which projects into the recess (45).

11. Flap transfer valve according to any one of Claims 1 to 10,
**characterized by**
• a pivot stop (50), which limits the pivoting angle, between the valve closure beam (4) and the support (40), and
• at least one spring (51) between the valve closure beam (4) and the support (40),
wherein
• the at least one spring (51) presses the valve closure beam (4) against the pivot stop (50) in the open position (O), and
• the valve closure beam (4) is tilted with respect to the support (40) when in the open position (O) such that, during pivoting of the support (40) and of the valve closure beam (4) by means of the pivoting bearing (60) from the open position (O) to the closed position (C) while making the contact between the first sealing surface (3) and the second sealing surface (9), these sealing surfaces (3, 9) come to rest flat on one another.

12. Flap transfer valve according to any one of Claims 1 to 11,
**characterized in that**
a pivoting shaft (61), which extends parallel to the first longitudinal axis (2) of the first opening (1) and along the pivoting axis (10), is arranged adjacent to the first opening (1), to which pivoting shaft (61) the support (40) is attached in order to pivot about the pivoting axis (10).

13. Flap transfer valve according to any one of Claims 1 to 12,
**characterized by**
• a shaft (11) which can rotate about a shaft axis (12), which is essentially parallel to the second longitudinal axis (5) and is at a distance from the pivoting axis (10),
• at least one drive (13), which is coupled to the shaft (11) in order to rotate the shaft (11) about the shaft axis (12) and to move the valve closure beam (4) between the open position (O) and the closed position (C), and
• at least one first arm (29), which is arranged on the shaft (11) such that they rotate together and whose free end engages directly or indirectly via the support (40) with the rear face (7) of the valve closure beam (4), such that rotation of the shaft (11), and therefore pivoting of the first arm (29), about the shaft axis (12) can result in a force being applied to the rear face (7) of the valve closure beam (4) in order to pivot the valve closure beam (4) about the pivoting axis (10) between the open position (O) and the closed position (C).

## Revendications

1. Soupape de transfert à clapets pour le transfert d'éléments semiconducteurs ou de substrats dans une chambre de traitement de semiconducteurs ou de substrats pouvant être isolée étanche au gaz avec
• une première ouverture (1) allongée, en particulier de type fente, qui s'étend le long d'un premier axe longitudinal (2) et qui est enserrée en forme de cadre par une première surface d'étanchéité (3),
• une barre de fermeture de soupape allongée (4)
- qui s'étend le long d'un second axe longitudinal (5) substantiellement parallèle au premier axe longitudinal (2),
- qui présente, sur un côté avant (6), une surface de fermeture (8) pour fermer la première ouverture (1) et
- une seconde surface d'étanchéité (9) qui
_{°} correspond à la première surface d'étanchéité (3),
_{°} qui peut être amenée en contact étanche au gaz avec la première surface d'étanchéité (3),
_{°} se situe dans la zone du bord de la surface de fermeture (8) et
_{°} se situe dans un second plan d'étanchéité géométrique (42),
• au moins un appui (40) sur un côté arrière (7) opposé au côté avant (6) de la barre de fermeture de soupape (4), la barre de fermeture de soupape (4) étant placée pivotante d'un angle de pivotement limité autour d'un axe de basculement (44) géométrique, parallèle au second axe longitudinal (5), par l'intermédiaire d'une jonction pivotante (43) sur l'appui (40) et
• un palier de pivotement (60), le palier de pivotement (60), la première ouverture (1) et la barre de fermeture (4) étant configurés tels qu'au moyen du palier de pivotement (60) l'appui (40) est pivotant avec la barre de fermeture de soupape (4) autour d'un axe de pivotement (10) géométrique, parallèle au second axe longitudinal (5) entre
- une position fermée (C) dans laquelle
_{°} la barre de fermeture de soupape (4) recouvre et ferme la première ouverture (1) avec la surface de fermeture (8),
_{°} la première surface d'étanchéité (3) de la première ouverture (1) et la seconde surface d'étanchéité (9) de la barre de fermeture de soupape (4) sont en contact étanche au gaz, sont parallèles et se situent dans un plan commun l'un sur l'autre et
_{°} le premier plan d'étanchéité (41) de la première surface d'étanchéité (3) de la première ouverture (1) et le second plan d'étanchéité (42) de la seconde surface d'étanchéité (9) de la barre de fermeture de soupape (4) se situent l'un sur l'autre et
- une position ouverte (O) dans laquelle la barre de fermeture de soupape (4) est éloignée par pivotement de la première ouverture (1) et qui libère au moins partiellement la première ouverture (1),
**caractérisée en ce que**
• l'axe de pivotement (10) se situe substantiellement dans le premier plan d'étanchéité (41) de la première surface d'étanchéité (3) de la première ouverture (1),
• l'axe de basculement (44) se situe substantiellement dans le second plan d'étanchéité (42) de la seconde surface d'étanchéité (9) de la barre de fermeture de soupape (4),
• la seconde surface d'étanchéité (9) qui se situe dans la zone du bord de la surface de fermeture (8) est décalée en arrière en direction du côté arrière (7) de telle manière que la surface de fermeture (8) fait saillie au delà du second plan d'étanchéité (42) en direction du côté avant (6) de la barre de fermeture de soupape (4) - au moins dans une zone du milieu de la barre de fermeture de soupape (4),
• au moins un évidement (45) est moulé sur le côté arrière (7) de la barre de fermeture (4) au moins dans la zone du milieu de la barre de fermeture de soupape (4), évidement qui s'étend au moins jusque dans le second plan d'étanchéité (42) en direction du côté avant (6), l'axe de basculement (44) s'étendant dans la zone de l'évidement (45) et
• la jonction pivotante (43) étant placée dans l'évidement (45).

2. Soupape de transfert à clapets selon la revendication 1, **caractérisée en ce que** la jonction pivotante (43) entre l'appui (40) et la barre de fermeture de soupape est formée par au moins
• une articulation basculante (43a),
• une articulation sphérique (43b) ou
• une articulation pivotante (43c).

3. Soupape de transfert à clapets selon la revendication 1, **caractérisée en ce que** la jonction pivotante (43) est formée par
• l'évidement (45) qui existe au moins et
• au moins une saillie (46) de l'appui (45),
• la saillie (46) faisant saillie dans l'évidement (45) et il y a un contact tel entre la saillie (46) et l'évidement (45) que la barre de fermeture de soupape (4) est pivotante par rapport à l'appui (40) autour de l'axe de basculement (41).

4. Soupape de transfert à clapets selon la revendication 3, **caractérisée en ce que**
• la jonction pivotante (43) est configurée comme une articulation basculante (43a),
• l'évidement (45) présente un fond (47) et
• la saillie (47) présente une section qui se termine en pointe avec une pointe (48) par rapport au plan qui est traversé par l'axe de basculement (44) et le second axe longitudinal (5),
cependant qu'il existe entre la pointe (48) et le fond (47) un contact en forme de point ou de ligne, situé sur l'axe de basculement (44), qui forme l'articulation basculante (43a).

5. Soupape de transfert à clapets selon la revendication 4, **caractérisée en ce que** la saillie (47) présente une section en forme de V et la pointe (48) est formée par l'angle V qui se termine en pointe.

6. Soupape de transfert à clapets selon la revendication 4 ou 5, **caractérisée en ce que** l'évidement (45) présente une section qui converge vers l'intérieur par rapport au plan qui est traversé perpendiculairement par l'axe de basculement (44) et le second axe longitudinal (5).

7. Soupape de transfert à clapets selon la revendication 6, **caractérisée en ce que** l'évidement (45) présente une section en forme de V et le fond (47) est formé par l'angle V qui se termine obtus.

8. Soupape de transfert à clapets selon l'une des revendications 3 à 7, **caractérisée en ce que**
• l'évidement (45) est configuré comme une rainure qui s'étend au moins partiellement le long de l'axe de basculement (44), le fond (47) de la rainure (45) étant situé dans le second plan d'étanchéité (42) et
• la saillie (46) étant configurée comme une clavette qui s'étend le long de l'axe de basculement (44).

9. Soupape de transfert à clapets selon l'une des revendications 3 à 8, **caractérisée par** un dispositif à ressort (49) entre la barre de fermeture de soupape (4) et l'appui (40), le dispositif à ressort (49) étant placé de telle manière que
• la barre de fermeture de soupape (4) est maintenue sur l'appui (40) et
• la saillie (46) est enfoncée dans l'évidement (45).

10. Soupape de transfert à clapets selon la revendication 9, **caractérisée en ce que** le dispositif à ressort (49) est configuré comme un ressort à lame, placé sur le côté arrière (7) de la barre de fermeture de soupape (4), qui est placé derrière la saillie (46) qui fait saillie dans l'évidement (45) et qui enfonce la saillie (46) dans l'évidement (45).

11. Soupape de transfert à clapets selon l'une des revendications 1 à 10, **caractérisée par**
• une butée de pivotement (50) qui limite l'angle de pivotement entre la barre de fermeture de soupape (4) et l'appui (40) et
• au moins un ressort (51) entre la barre de fermeture de soupape (4) et l'appui (40),
cependant que
• le ressort qui existe au moins (51), en position ouverte (O), pousse la barre de fermeture de soupape (4) contre la butée de pivotement (50) et
• la barre de fermeture de soupape (4), en position ouverte (O), est basculée par rapport à l'appui (40) de telle manière que, lors du pivotement de l'appui (40) et de la barre de fermeture de soupape (4) au moyen du palier de pivotement (60) de la position ouverte (O) à la position fermée (C) lors de la réalisation du contact entre la première surface d'étanchéité (3) et la seconde surface d'étanchéité (9), ces surfaces d'étanchéité (3, 9) viennent se poser de manière plane l'une sur l'autre.

12. Soupape de transfert à clapets selon l'une des revendications 1 à 11, **caractérisée en ce qu'**un arbre de pivotement (61) qui s'étend parallèlement au premier axe longitudinal (2) de la première ouverture (1) et le long de l'axe de pivotement (10) est placé à côté de la première ouverture (1), arbre sur lequel l'appui (40) est fixé pour pivoter autour de l'axe de pivotement (10).

13. Soupape de transfert à clapets selon l'une des revendications 1 à 12, **caractérisée par**
• un arbre (11) qui est rotatif autour d'un axe d'arbre (12), qui est espacé de l'axe de pivotement (10) et qui est substantiellement parallèle au second axe longitudinal (5)
• au moins un entraînement (13) qui est couplé à l'arbre (11) pour tourner l'arbre (11) autour de l'axe d'arbre (12) et pour ajuster la barre de fermeture de soupape (4) entre la position ouverte (O) et la position fermée (C) et
• au moins un premier bras (29) placé résistant à la rotation sur l'arbre (11), bras qui est en engrènement à son extrémité libre directement ou indirectement par l'appui (40) avec le côté arrière (7) de la barre de fermeture de soupape (4) de telle manière qu'une force peut être appliquée par la rotation de l'arbre (11) et ainsi par le pivotement du premier bras (29) autour de l'axe d'arbre (12) sur le côté arrière (7) de la barre de fermeture de soupape (4) pour pivoter la barre de fermeture de soupape (4) autour de l'axe de pivotement (10) entre la position ouverte (O) et la position fermée (C).
